# EUROPEAN PATENT APPLICATION

(11) **EP 2 858 093 A1**
(43) Date of publication of application: **08.04.2015**
(21) Application number: 13793970.8
(22) Date of filing: 15.05.2013
(51) Int. Cl.: H01L 21/027, B81C 99/00, C08F 2/50

(54) **PHOTOCURABLE RESIN COMPOSITION FOR IMPRINTING, METHOD FOR PRODUCING SAME, AND STRUCTURE**

(30) Priority: 25.05.2012 JP 2012119528
(71) Applicant: Soken Chemical & Engineering Co., Ltd., Toshima-ku Tokyo 171-8531 (JP)
(72) Inventor: YAMADA, Hiroko, Sayama-shi Saitama 350-1320 (JP); SUTO, Yasuo, Sayama-shi Saitama 350-1320 (JP); MIYAZAWA, Yukihiro, Sayama-shi Saitama 350-1320 (JP)
(74) Representative: Matthews, Derek Peter
(86) International application number: PCT/JP2013/063566
(87) International publication number: WO 2013/176020

(57) **Abstract**

Provided are a photocurable resin composition in which curing shrinkage in photo-imprinting is suppressed, and a photocurable resin composition capable of producing by photo-imprinting a structure which has high surface hardness and in which the occurrence of yellowing is suppressed even when irradiated with e.g., ultraviolet ray. The photocurable resin composition for imprinting includes a (meth)acrylic monomer (A) and a photoinitiator (B), wherein the photoinitiator (B) has a combination of an alkylphenone-based photoinitiator (B1) and an acylphosphine oxide-based photoinitiator (B2), wherein a blending weight ratio (B1: B2) of the alkylphenone-based photoinitiator (B1) to the acylphosphine oxide-based photoinitiator (B2) is in the range of 1:99 to 90:10.

## Description

### Technical Field

The present invention relates to a photocurable resin composition for imprinting; a method for producing a structure using the photocurable resin composition; and a structure formed by using the photocurable resin composition.

### Background Art

In imprinting technology, a master mold having a surface on which a fine structure at nano- or micron-scale is formed is pressed on a liquid resin, whereby the fine structure of the mold is transferred onto the resin. A structure having the fine structure formed by transferring, according to the shape of the fine structure, is used as an imprinting mold, an antireflection film, a diffusion film or the like, in various fields including semiconductor materials, optical materials, recording media, micro machines, biology and environment.

Exemplary methods for imprinting are thermal imprinting, in which a mold having a surface with a predetermined shape is press-contacted with a thermoplastic resin that has been molten at a temperature exceeding its glass transition temperature, whereby the surface shape of the mold is thermally imprinted on the thermoplastic resin, which is followed by cooling and mold-detaching; and photo-imprinting in which such a mold as described above is pressed on a photocurable resin, which is followed by ultraviolet ray application to cure the photocurable resin, and then mold-detaching.

In the photo-imprinting, a problem occurs that the resin while being cured undergoes curing shrinkage and fails to precisely reflect the shape of the original mold. In the photo-imprinting including transferring a fine structure at nano- or micron-scale, even dimensional difference at nano- or micron-scale is a problem.

In particular, when a structure produced by photo-imprinting is used as a mold for photo-imprinting, it is also important that the mold do not have decreased transmittance due to yellowing as a result of repeated application of ultraviolet ray, and it is also demanded that the mold have enough hardness not to break because of repeated imprinting operation.

The yellowing and curing shrinkage of the resin often vary depending on a photoinitiator used.

Patent Literature 1, directed to a resin mold formed by using a fluorine-containing monomer by means of photo-imprinting, discloses combining two kinds of initiators in view of dispersibility of the fluorine-containing monomer and curability of a photopolymerizable mixture. Patent Literature 1 describes in its Example a combination of Irgacure184 and Irgacure369 as a photoinitiator contained in the photocurable resin composition; however, both are alkylphenone-based photoinitiators.

Thus, there is a need to further study photoinitiators from the viewpoints of curing shrinkage of resin and the hardness and yellowing of the resultant structure.

### Citation List

### Patent Literatures

[Patent Literature 1] JP-A-2011-207221

### Summary of the Invention

### Technical Problem

It is an object of the present invention to provide a photocurable resin composition in which curing shrinkage in photo-imprinting is suppressed. It is another object of the present invention to provide a photocurable resin composition capable of producing by photo-imprinting a structure which has high surface hardness and in which the occurrence of yellowing is suppressed even when irradiated with e.g., ultraviolet ray.

### Technical Solution

The present inventors focused on a combination of plural photoinitiators of a photocurable resin composition and extensively studied its influence on the yellowing, curing shrinkage and hardness of a structure obtainable from the composition by photo-imprinting, and have found that by combining photoinitiators belonging to specific types at a specific ratio, the yellowing of the structure obtained by photo-imprinting is suppressed, and moreover the curing shrinkage of the structure can be considerably decreased, thereby perfecting the present invention. The structure thus obtained has superior hardness.

The present invention concerns, for example, [1] to [14] described below.
[1] A photocurable resin composition for imprinting comprising a (meth) acrylic monomer (A) and a photoinitiator (B), wherein the photoinitiator (B) comprises a combination of an alkylphenone-based photoinitiator (B1) and an acylphosphine oxide-based photoinitiator (B2), wherein a blending weight ratio (B1: B2) of the alkylphenone-based photoinitiator (B1) to the acylphosphine oxide-based photoinitiator (B2) is in the range of 1:99 to 90:10.
[2] The photocurable resin composition for imprinting according to [1], wherein with respect to 100 parts by weight of the (meth)acrylic monomer (A), the alkylphenone-based photoinitiator (B1) is contained at 0.01 to 20 parts by weight and the acylphosphine oxide-based photoinitiator (B2) is contained at 0.01 to 20 parts by weight.
[3] The photocurable resin composition for imprinting according to [1] or [2], wherein the alkylphenone-based photoinitiator (B1) is at least one kind selected from the group consisting of 2,2-dimethoxy-1,2-diphenylethane-1-one, 1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-o ne and 2-hydroxy-1-{[4-(2-hydroxy-2-methylpropionyl)-benzyl]phenyl}-2-methyl-propane-1-one.
[4] The photocurable resin composition for imprinting according to any one of [1] to [3], wherein the acylphosphine oxide-based photoinitiator (B2) is at least one kind selected from the group consisting of 2,4,6-trimethylbenzoyl-diphenyl-phosphine oxide and bis(2,4,6-trimethylbenzoyl)-phenylphosphine oxide.
[5] The photocurable resin composition for imprinting according to [4], wherein the alkylphenone-based photoinitiator (B1) is 1-hydroxy-cyclohexyl-phenyl-ketone and the acylphosphine oxide-based photoinitiator (B2) is bis(2,4,6-trimethylbenzoyl)-phenylphosphine oxide, and wherein a blending weight ratio (B1: B2) of the alkylphenone-based photoinitiator (B1) to the acylphosphine oxide-based photoinitiator (B2) is in the range of 10:90 to 70:30.
[6] A method for producing a structure having a surface on which a fine pattern is formed, comprising:
   (I) a step of applying, on a substrate, the photocurable resin composition for imprinting according to any one of [1] to [5],
   (II) a step of bringing a master mold having a surface on which a fine pattern is formed into contact with the photocurable resin composition for imprinting applied on the substrate,
   (III) a step of applying light to the photocurable resin composition for imprinting provided between the substrate and the master mold to cure the photocurable resin composition for imprinting, and
   (IV) a step of releasing the master mold from the photocurable resin composition for imprinting that has been cured.
[7] A method for producing a structure having a surface on which a fine pattern is formed, comprising:
   (I) a step of dropwise adding the photocurable resin composition for imprinting according to any one of [1] to [5] on a master mold having a surface on which a fine pattern is formed,
   (II) a step of covering a surface of the photocurable resin composition for imprinting with a substrate,
   (III) a step of applying light to the photocurable resin composition for imprinting provided between the substrate and the master mold to cure the photocurable resin composition for imprinting, and
   (IV) a step of releasing the master mold from the photocurable resin composition for imprinting that has been cured.
[8] A structure obtained by the production method according to [6] or [7].
[9] The structure according to [8], which has a fine pattern with a shrinkage factor of not more than 10% with respect to the fine pattern of the master mold.
[10] The structure according to [8] or [9], wherein a value obtained by subtracting a YI value of the structure before irradiated with light at 18,000 mJ/cm² from a YI value of the structure after irradiated with light at 18,000 mJ/cm² is 0.0 to 3.0.
[11] The structure according to any one of [8] to [10], which has a surface hardness of 3B to 3H in terms of pencil hardness in accordance with JIS K5600 5-4.
[12] The structure according to any one of [8] to [11], wherein the structure is an imprinting mold.
[13] The structure according to any one of [8] to [11], wherein the structure is an antireflection film.
[14] The structure according to any one of [8] to [11], wherein the structure is a diffusion film.

### Effects of the Invention

According to the present invention, the curing shrinkage in photo-imprinting of a photocurable resin composition is suppressed and a structure faithful to a shape of an original mold at a nano-order scale can be obtained. The structure obtained from the photocurable resin composition of the present invention by photo-imprinting has high surface hardness. In addition, yellowing of the resultant structure that is caused by the application of e.g., ultraviolet ray is suppressed.

### Description of Embodiments

Hereinafter, the present invention will be specifically described.

The present invention is a photocurable resin composition for imprinting comprising a (meth)acrylic monomer (A) and a photoinitiator (B), wherein the photoinitiator (B) comprises a combination of an alkylphenone-based photoinitiator (B1) and an acylphosphine oxide-based photoinitiator (B2), wherein a blending weight ratio (B1: B2) of the alkylphenone-based photoinitiator (B1) to the acylphosphine oxide-based photoinitiator (B2) is in the range of 1:99 to 90:10.

In the specification, " (meth) acryl" means methacryl and/or acryl, and "(meth)acrylate" means methacrylate and/or acrylate.

### <Photocurable Resin Composition for Imprinting>

### 1. (Meth)acrylic monomer (A)

In the photocurable resin composition for imprinting of the present invention, a photopolymerizable (meth) acrylic monomer is used.

Examples of the photopolymerizable (meth)acrylic monomer include multifunctional (meth)acrylic acid esters, monofunctional (meth)acrylic acid esters and functional group-containing monomers.

Examples of the multifunctional (meth)acrylic acid esters used in the present invention include ethylene oxide-modified trimethylolpropane tri(meth)acrylate, ethylene oxide-modified bisphenol A di(meth)acrylate, tripropylene glycol di(meth)acrylate, 1,4-butanediol di(meth)acrylate, 1,6-hexanediol di(meth)acrylate, 1,9-nonanediol di(meth)acrylate, (poly)ethylene glycol di(meth)acrylate, (poly)propylene glycol di(meth)acrylate, neopentyl glycol di(meth)acrylate, pentaerythritol di(meth)acrylate, pentaerythritol tri(meth)acrylate, pentaerythritol tetra(meth)acrylate, trimethylolpropane di(meth)acrylate, trimethylolpropane tri(meth)acrylate, polyester (meth)acrylate and urethane (meth)acrylate.

In the present invention, in addition to the multifunctional (meth) acrylic acid esters as described above, the monofunctional (meth)acrylic acid esters may be used. Examples of the monofunctional (meth) acrylic acid esters that may be used include :
(meth) acrylates having a linear alkyl group, such as methyl (meth)acrylate, ethyl (meth)acrylate, n-propyl (meth)acrylate, n-butyl (meth)acrylate, n-pentyl (meth)acrylate, n-hexyl (meth)acrylate, n-octyl (meth)acrylate, n-nonyl (meth)acrylate, decyl (meth)acrylate, dodecyl (meth)acrylate and stearyl (meth)acrylate;
(meth)acrylic acid alkyl esters having a branched alkyl group, such as iso-propyl (meth)acrylate, iso-butyl (meth)acrylate, tert-butyl (meth)acrylate, 2-ethylhexyl (meth)acrylate and isooctyl (meth)acrylate;
(meth) acrylic acid alkyl esters having a cyclic alkyl group, such as isobornyl (meth)acrylate and cyclohexyl (meth)acrylate; and
(meth)acrylic acid esters having an aromatic group, such as benzyl (meth)acrylate and phenoxyethyl (meth)acrylate.

Examples of the functional group-containing monomers include hydroxyl group-containing monomers, acid group-containing monomers, amino group-containing monomers, amide group-containing monomers and cyano group-containing monomers.

Examples of the hydroxyl group-containing monomers are hydroxyl group-containing compounds such as hydroxyl group-containing (meth)acrylic monomers including (meth)acrylic acid-2-hydroxyethyl, (meth)acrylic acid-2-hydroxypropyl, (meth)acrylic acid-4-hydroxybutyl, a monoester formed by (meth)acrylic acid and polypropylene glycol or polyethylene glycol, and an adduct formed by lactones and (meth)acrylic acid-2-hydroxyethyl .

Examples of the acid group-containing monomers include carboxyl group-containing (meth)acrylic monomers such as (meth)acrylic acid, acid anhydride group-containing (meth)acrylic monomers, phosphoric acid group-containing (meth)acrylic monomers and sulfuric acid group-containing (meth)acrylic monomers.

Examples of the amino group-containing monomers or amide group-containing monomers include amino group-containing (meth)acrylic monomers such as N,N-dimethylaminoethyl (meth) acrylate and amide group-containing (meth) acrylic monomers such as (meth)acrylamide, N-methyl(meth)acrylamide, N-ethyl(meth)acrylamide, N-propyl(meth)acrylamide and N-hexyl(meth)acrylamide.

Examples of the cyano group-containing monomers include cyano(meth)acrylates.

As the (meth) acrylic monomer (A), in addition to the (meth)acrylic monomers described above, other (meth)acrylic monomers copolymerizable with the above (meth)acrylic monomers as described below can be mentioned.

Examples of the other copolymerizable (meth)acrylic monomers include epoxy group-containing (meth)acrylates such as glycidyl (meth)acrylate and 4-hydroxybutyl (meth)acrylate glycidyl ether, alkoxy(meth)acrylates and allyl(meth)acrylates.

In 100 parts by weight of the (meth)acrylic monomer (A), the multifunctional (meth) acrylic acid ester preferably accounts for 50 to 100 parts by weight, more preferably 70 to 100 parts by weight; the monofunctional (meth) acrylic acid ester preferably accounts for 0 to 30 parts by weight, more preferably 0 to 20 parts by weight; the functional group-containing monomer preferably accounts for 0 to 30 parts by weight, more preferably 0 to 10 parts by weight; and the other copolymerizable (meth)acrylic monomer preferably accounts for 0 to 30 parts by weight, more preferably 0 to 10 parts by weight. A composition of the (meth)acrylic monomer (A) in the above ranges is preferred in terms of surface hardness.

Among the (meth)acrylic monomers (A), monomers of ethylene oxide-modified trimethylolpropane triacrylate, ethylene oxide-modified bisphenol A diacrylate and tripropylene glycol diacrylate are preferred.

The photocurable resin composition for imprinting of the present invention may contain, in addition to the (meth)acrylic monomer (A), other photopolymerizable monomers in a range that is not detrimental to characteristics of the present invention. Examples of the other photopolymerizable monomers are styrene-based monomers and vinyl-based monomers.

Examples of the styrene-based monomers include styrene; alkyl styrenes such as methylstyrene, dimethylstyrene, trimethylstyrene, ethylstyrene, diethylstyrene, triethylstyrene, propylstyrene, butylstyrene, hexylstyrene, heptylstyrene and octylstyrene; halogenated styrenes such as fluorostyrene, chlorostyrene, bromostyrene, dibromostyrene and iodostyrene; nitrostyrene, acetylstyrene and methoxystyrene.

Examples of the vinyl-based monomers include vinylpyridine, vinylpyrrolidone, vinylcarbazole, divinylbenzene, vinyl acetate and acrylonitrile; conjugated diene monomers such as butadiene, isoprene and chloroprene; halogenated vinyls such as vinyl chloride and vinyl bromide; halogenated vinylidenes such as vinylidene chloride.

In the photocurable resin composition for imprinting of the present invention, the amount of the other photopolymerizable monomer excluding the (meth)acrylic monomer (A) is preferably 0 to 30 parts by weight, more preferably 0 to 10 parts by weight, with respect to 100 parts by weight of the (meth) acrylic monomer (A) in the photocurable resin composition for imprinting. By using the photopolymerizable monomer other than the (meth) acrylic monomer (A) in the above amount, a resin mold that is rigid and has good precision can be formed.

The (meth)acrylic monomers and other photopolymerizable monomers mentioned above as examples can be used singly or in combination of two or more kinds.

### 2. Photoinitiator (B)

In the photocurable resin composition for imprinting of the present invention, the alkylphenone-based photoinitiator (B1) and the acylphosphine oxide-based photoinitiator (B2) are used in combination as a photoinitiator.

Using the alkylphenone-based photoinitiator (B1) and the acylphosphine oxide-based photoinitiator (B2) in combination as a photoinitiator is believed to make polymerization rate moderately low and to cause polymerization to proceed in such a manner that unpolymerized part of the resin composition is incorporated into between a resin polymerized and shrunk and the master mold, whereby the curing shrinkage of a structure obtainable from the composition of the present invention by photocuring can be decreased; and the resin polymerized later is believed to adequately form a crosslinked structure on the surface and provide the surface with higher hardness than the resin polymerized earlier, so that increased surface hardness is attained.

In the present invention, the amounts of both the photoinitiators in the photocurable resin composition for imprinting with respect to 100 parts by weight of the (meth) acrylic monomer (A) in the photocurable resin composition for imprinting are such that the alkylphenone-based photoinitiator (B1) is used preferably at 0.01 to 20 parts by weight, more preferably 0.1 to 15 parts by weight, further preferably 0.5 to 10 parts by weight, and the acylphosphine oxide-based photoinitiator (B2) is used preferably at 0.01 to 20 parts by weight, more preferably 0.1 to 15 parts by weight, further preferably 0.5 to 10 parts by weight.

Using the alkylphenone-based photoinitiator (B1) and the acylphosphine oxide-based photoinitiator (B2) in the above ranges can control radical generation amount.

A weight ratio (B1: B2) of the alkylphenone-based photoinitiator (B1) to the acylphosphine oxide-based photoinitiator (B2) is in the range of 1:99 to 90:10, preferably 5:95 to 80:20, more preferably 10:90 to 70:30.

By using the alkylphenone-based photoinitiator (B1) and the acylphosphine oxide-based photoinitiator (B2) at the weight ratio described above, a relatively hard polymer can be formed at a polymerization rate that is moderately low, and yellowing of the resulting polymer can be suppressed.

The alkylphenone-based photoinitiator is preferably a nitrogen-free compound. A more preferred example is at least one kind selected from the group consisting of
2,2-dimethoxy-1,2-diphenylethane-1-one,
1-hydroxy-cyclohexyl-phenyl-ketone,
2-hydroxy-2-methyl-1-phenyl-propane-1-one,
1-[4-(2-hydroxyethoxy)-phenyl]-2-hydroxy-2-methyl-propane-1-o ne and
2-hydroxy-1-{[4-(2-hydroxy-2-methyl-propionyl)-benzyl]phenyl} -2-methyl-propane-1-one; and most preferred is 1-hydroxy-cyclohexyl-phenyl-ketone.

Examples of commercially-available products of the alkylphenone-based photoinitiators include IRGACURE651, IRGACURE184, IRGACURE2959, IRGACURE127, IRGACURE907 and IRGACURE369 (each of these is manufactured by BASF) and IRGACURE1173 (manufactured by Ciba Japan K.K).

The acylphosphine oxide-based photoinitiator is preferably at least one kind selected from the group consisting of 2,4,6-trimethylbenzoyl-diphenyl-phosphine oxide and bis(2,4,6-trimethylbenzoyl)-phenylphosphine oxide; and bis(2,4,6-trimethylbenzoyl)-phenylphosphine oxide is most preferred.

Examples of commercially-available products of the acylphosphine oxide-based photoinitiators include LUCIRIN TPO and IRGACURE819 (each of these is manufactured by BASF).

### 3. Others

The photocurable resin composition for imprinting of the present invention may contain components such as a solvent, a chain transfer agent, an antioxidant, a photosensitizer, a filler and a leveling agent, in a range that is not detrimental to properties of the photocurable resin composition for imprinting.

The photocurable resin composition for imprinting of the present invention can be produced by mixing the above components through a known method.

### <Photocurable Resin Composition for Imprinting Usage Method>

The photocurable resin composition for imprinting of the present invention is used for photo-imprinting conducted for producing a structure having a surface on which a fine pattern of e.g., a master mold is formed.

The photo-imprinting includes:
(1-1) a step of applying, on a substrate, the photocurable resin composition for imprinting of the present invention,
(II-1)a step of bringing a master mold having a surface on which a fine pattern is formed into contact with the photocurable resin composition for imprinting applied on the substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

The steps (1-1) and (II-1) may be:
(1-2) a step of dropwise adding the photocurable resin composition for imprinting of the present invention on a master mold having a surface on which a fine pattern is formed, and
(II-2) a step of covering a surface of the photocurable resin composition for imprinting with a substrate, respectively.

Consequently, a structure having a surface on which the fine pattern of the surface of the master mold has been transferred is produced.

Examples of the substrate used in the steps (I-1) and (11-2) include resins, glass, silicon, sapphire, gallium nitride, carbon and silicon carbide.

Preferred examples of the resins used for the substrate include polyethylene terephthalate, polycarbonate, polyester, methyl polymethacrylate, polystyrene, polyolefin, polyimide, polysulfone, polyether sulfone and polyethylene naphthalate.

As a form of the resin used for the substrate, the resin in a plate form and the resin in a film form can be mentioned. The form is selected according to imprinting mode.

Exemplary methods of applying on the substrate the photocurable resin composition for imprinting of the present invention in the step (1-1) include spin coating, spray coating, bar coating, dip coating, die coating and slit coating.

The amount of the photocurable resin composition for imprinting of the present invention to be applied on the substrate in the step (1-1) and to be dropwise added to the master mold in the step (I-2) is preferably 1×10⁻⁴ to 1×10⁻¹g/cm², more preferably 1×10⁻³ to 1×10⁻²g/cm².

The fine pattern formed on the surface of the master mold in the steps (II-1) and (I-2) is generally a concave-convex pattern repeating in a predetermined cycle: specifically, a concave-convex pattern preferably having a cycle of 10 nm to 50 µm, a depth of 10 nm to 100 µm, and a transferred surface of 1.0 to 1.0×10⁶mm².

Specific examples of the concave-convex form include moth-eye, line, column, monolith, cone, polygonal pyramid and microlens array.

In the step (II-1), the master mold is brought into contact with the photocurable resin composition for imprinting of the present invention generally at a strength of 1.0×10⁻³ to 1.0 MPa and generally kept for 1 to 300 seconds.

Examples of the light used in the step (III) are active energy rays including ultraviolet ray, visible ray, infrared ray and electron ray. Light is generally applied at 100 to 18,000 mJ/cm².

In the step (IV), an operation of releasing the master mold from the cured resin is performed.

By the photo-imprinting described above, the photocurable resin composition for imprinting of the present invention is formed into a structure having a surface on which the fine pattern of the master mold has been transferred.

### <Structure Obtained from Photocurable Resin Composition for Imprinting>

### 1. Properties of Structure

The structure having a surface on which the fine pattern of the master mold has been transferred which is obtained from the photocurable resin composition for imprinting of the present invention by photo-imprinting has properties described below.

The fine pattern formed on the surface of the structure preferably has a shrinkage factor of not more than 10%, more preferably 0 to 3% with respect to the fine pattern of the master mold, as measured by a method described in Examples.

The shrinkage factor as described above is possible because of using the alkylphenone-based photoinitiator (B1) and the acylphosphine oxide-based photoinitiator (B2) in combination as a photoinitiator used in the photocurable resin composition for imprinting of the present invention.

Using the photoinitiators described above in combination makes polymerization rate moderately low and causes polymerization to proceed in such a manner that unpolymerized part of the resin composition is incorporated into between a resin polymerized and shrunk and the master mold, resulting in decrease of curing shrinkage.

The structure preferably has a surface hardness of 3B to 3H, preferably B to H, as measured by a method described in Examples. The surface hardness described above is believed to be possible because of a more amount of the multifunctional monomer in the photocurable resin composition for imprinting of the present invention thereby allowing its cured product to have increased crosslinking density.

The structure preferably has a YI value of 0.5 to 20, more preferably 1 to 10, as measured by a method described in Examples. It is preferred that a value obtained by subtracting a YI value of the structure before irradiated with light at 18,000 mJ/cm² from a YI value of the structure after irradiated with light at 18, 000 mJ/cm² is 0.0 to 3.0, more preferably 0.0 to 2.0. By the above feature, the structure has high transmittance. Thus, when the structure of the present invention is used for imprinting mold, the mold even when exposed to repeated light application hardly undergoes yellowing and the decrease of its transmittance is suppressed.

The reason why yellowing of the structure is suppressed is because the photoinitiator used in the photocurable resin composition for imprinting of the present invention is the combination of the alkylphenone-based photoinitiator (B1) and the acylphosphine oxide-based photoinitiator (B2) at the weight ratio and amounts described above. By virtue of the combination of these initiators at the weight ratio and amounts described above, the individual photoinitiators are believed to cooperate with each other to control the generation of radicals leading to the suppression of yellowing.

### 2. Use of Structure

The structure is used for an imprinting mold, an antireflection film, a diffusion film, a cell culturing sheet.

In imprinting mold use, the structure having a surface on which a pattern is formed preferably has nano or micro concave-convex configuration with various shapes adapted to various uses. In antireflection film use, the structure having a surface on which a moth eye-shaped pattern is formed is preferable. In diffusion film use, the structure having a surface on which a microlens array-shaped pattern is formed is preferable.

### Examples

Hereinafter, the present invention will be further specifically described with reference to Examples, but the present invention is not limited to these Examples.

A sample was produced in such a manner as described below.

To a nickel master mold described in Table 2 or a resin master mold described in Table 4 that were subjected to releasing treatment using a fluorine-based releasing agent (OPTOOL HD-2100, manufactured by DAIKIN INDUSTRIES, Ltd.), a resin composition of any of Example 1 and Comparative Examples 1 and 2 was dropwise added. The resin composition was covered with a PET (polyethylene terephthalate) substrate. Then, on the substrate, a roller was rolled so that the resin liquid was evenly extended (2.5×10⁻³g/cm²). Thereafter, UV light was applied at 1800 mJ/cm² by using a UV application device (UVC-408 manufactured by Technovision, Inc.) to cure the resin. Thereafter, the PET/cured resin laminate was released from the mater mold, to obtain a sample. The sample thus obtained was referred to as the "structure" hereinafter.

Onto a nickel plate having no fine structure that was subjected to releasing treatment using a fluorine-based releasing agent (OPTOOL HD-2100, manufactured by DAIKIN INDUSTRIES, Ltd.), the resin composition of any of Examples 1 to 4 and Comparative Examples 1 to 4 was dropwise added. The resin composition was covered with a PET (polyethylene terephthalate) substrate (thickness: 188 µm, transmittance (365 nm) 80%). On the substrate, a roller was rolled so that the resin liquid was evenly extended (2.5×10⁻³g/cm²). Thereafter, UV light was applied at an accumulated light quantity of 1800 mJ/cm² by using a UV application device (UVC-408 manufactured by Technovision, Inc.) to cure the resin. Thereafter, the PET/cured resin laminate was released from the plate, to obtain a sample. The sample thus obtained was referred to as the "cured resin" hereinafter.

Measured values in examples were obtained as follows.

### <Measurement of Dimension>

Considering that curing shrinkage is observed conspicuously in the direction of the height of a shape, the height (distance between the top of the convex part and a base surface) of a shape of the master mold and of the structure obtained was measured. For the measurement, as a measuring instrument, L-trace, manufactured by SII Nano Technology, Inc., was used. Six types of master molds (one type of line and space of 100 nm pitch, and five types of nano-hole shapes) and structures obtained from the resin compositions of Example 1 and Comparative Examples 1 and 2 by using the six types of master mold were subjected to the measurement. Heights at five places in each shape were averaged. Results are shown in Table 2.

### <Surface Hardness>

In accordance with pencil hardness stipulated in JIS K5600-5-4, surface hardnesses of the cured resins were measured. Results are shown in Table 3.

### <Yellowing Degree>

The cured resins obtained from the resin compositions of Examples and Comparative Examples, and cured resins given after applying UV to the above cured resins at an accumulated light quantity of 18,000 mJ/cm² were subjected to YI value measurement using a measuring instrument (a general-purpose color difference meter, Color Ace TC-8600A, manufactured by Tokyo Denshoku, limited private company). YI values of the cured resins and the cured resins irradiated are shown in Table 3.

### <Transmittance (Table 3)>

Transmittances in thickness with respect to light at 365 nm of the cured resins obtained from the resin compositions of Examples and Comparative Examples, and cured resins given after applying UV to the above cured resins at an accumulated light quantity of 18,000 mJ/cm² were measured by using a measuring instrument (V-670, ultraviolet-visible near infrared spectrophotometer, manufactured by JASCO Corporation) with a PET substrate used as blank. The transmittances of the cured resins and of the cured resins given after the irradiation are shown in Table 3.

### <Transmittance (Table 4)>

Transmittances in thickness with respect to lights (i-ray (365 nm), F-ray (486 nm), and D-ray (589 nm)) of the structures obtained from the resin compositions of Examples and Comparative Examples by using a moth-eye-shaped mold described in Table 4 as a master mold, and of the cured resins given after applying UV to the above structures at an accumulated light quantity of 18, 000 mJ/cm² were measured by using a measuring instrument (V-670, ultraviolet-visible near infrared spectrophotometer, manufactured by JASCO Corporation). The transmittances before and after the irradiation are shown in Table 4.

### [Examples 1 to 4]

To 75 parts by weight of tripropylene glycol diacrylate (TPGDA), 20 parts by weight of methylmethacrylate (MMA) and 5 parts by weight of glycidyl methacrylate (GMA), 1-hydroxy-cyclohexyl-phenyl-ketone ("IRGACURE184" manufactured by BASF) and bis(2,4,6-trimethylbenzoyl)-phenylphosphine oxide ("IRGACURE819" manufactured by BASF) were incorporated as a photoinitiator in an amount shown in Table 1, to prepare a photocurable resin composition. Compositions of these components are shown in Table 1.

### [Comparative Examples 1 to 4]

As a Comparative Example, IRGACURE819 used in the above Examples was replaced with 2-methyl-1-(4-methylthiophenyl)-2-morpholinopropane-1-one ("IRGACURE907" manufactured by BASF) or with 2-benzyl-2-dimethylamino-1-(4-morpholinophenyl)-butanone-1 ("IRGACURE369" manufactured by BASF) in an amount shown in Table 1, to prepare a photocurable resin composition. Compositions of these components are shown in Table 1.

[Table 1]

**Table 1**

| | Example 1 | Example 2 | Example 3 | Example 4 | Comparative Example 1 | Comparative Example 2 | Comparative Example 3 | Comparative Example 4 |
|---|---|---|---|---|---|---|---|---|
| TPGDA | 75 | 75 | 75 | 75 | 75 | 75 | 75 | 75 |
| MMA | 20 | 20 | 20 | 20 | 20 | 20 | 20 | 20 |
| GMA | 5 | 5 | 5 | 5 | 5 | 5 | 5 | 5 |
| Ir369 | | | | | | 3 | | 5 |
| Ir907 | | | | | 3 | | 5 | |
| Ir819 | 5 | 3 | 3 | 2 | | | | |
| Ir184 | 1 | 3 | 1 | 2 | 1 | 1 | 1 | 1 |

[Table 2]

**Table 2**

| Shape of Mold | Height (nm) | | | |
|---|---|---|---|---|
| | Master mold | Example 1 | Comparative Example 1 | Comparative Example 2 |
| L&S | 203.3 | 204.0 | 196.0 | 204.2 |
| Nano-hole (1) | 206.3 | 206.9 | 197.9 | 206.8 |
| Nano-hole (2) | 177.3 | 175.0 | 168.0 | 175.8 |
| Nano-hole (3) | 184.8 | 187.2 | 180.6 | 187.0 |
| Nano-hole (4) | 491.6 | 492.4 | 487.8 | 492.1 |
| Nano-hole (5) | 276.3 | 276.6 | 263.2 | 277.3 |

[Table 3]

**Table 3**

| | Example 1 | | Example 2 | | Example 3 | | Example 4 | |
|---|---|---|---|---|---|---|---|---|
| UV-irradiated | Resin composition | Cured resin | Resin composition | Cured resin | Resin composition | Cured resin | Resin composition | Cured resin |
| Accumulated light quantity (mJ/cm²) | 1,800 | 18,000 | 1,800 | 18,000 | 1,800 | 18,000 | 1,800 | 18,000 |
| Surface hardness | F | F | F | F | F | F | F | F |
| YI value | 5.4 | 5.4 | 4.6 | 5.6 | 4.3 | 4.9 | 4.5 | 4.7 |
| ΔYI | 0.0 | | 1.0 | | 0.6 | | 0.2 | |
| Thickness (µm) | 30 | | 25 | | 20 | | 20 | |
| Transmittance (365 nm) (%) | 59.3 | 67.1 | 65.7 | 67.1 | 69.7 | 69.8 | 69.8 | 70.9 |

| | Comparative Example 1 | | Comparative Example 2 | | Comparative Example 3 | | Comparative Example 4 | |
|---|---|---|---|---|---|---|---|---|
| UV-irradiated | Resin composition | Cured resin | Resin composition | Cured resin | Resin composition | Cured resin | Resin composition | Cured resin |
| Accumulated light quantity (mJ/cm²) | 1,800 | 18,000 | 1,800 | 18,000 | 1,800 | 18,000 | 1,800 | 18,000 |
| Surface hardness | F | F | F | F | F | F | F | F |
| YI value | 3.9 | 25.0 | 13.8 | 20.0 | 6.0 | 20.6 | 15.9 | 40.2 |
| ΔYI | 21.1 | | 6.2 | | 14.6 | | 24.3 | |
| Thickness (µm) | 20 | | 30 | | 50 | | 30 | |
| Transmittance (365 nm)(%) | 57.9 | 24.7 | 48.0 | 30.8 | 59.4 | 26.5 | 28.4 | 12.0 |

[Table 4]

**Table 4 Transmittances before and after structures are irradiated with light at 18,000 mJ/cm²**

| | | Moth-eye mold | Example1 | | Comparative Example 1 | | Comparative Example 2 | |
|---|---|---|---|---|---|---|---|---|
| Height [nm] | | 276.3 | 276.6 | | 263.2 | | 277.3 | |
| UV application | | - | Before | After | Before | After | Before | After |
| Transmittance (%) | i-ray | - | 63.9 | 64.0 | 64.7 | 49.2 | 51.3 | 45.4 |
| | F-ray | - | 92.6 | 92.5 | 92.4 | 91.3 | 92.3 | 91.0 |
| | D-ray | - | 93.3 | 93.3 | 93.3 | 93.1 | 93.5 | 93.1 |

It was verified from Table 2 that the present invention resin was much superior in the precision of shape dimension, an important factor in nano-imprinting.

It was verified from Table 3 that the cured resins of Examples 1 to 4 were free from yellowing and thus were able to retain transmittance, an important property for a mold. It was observed that the structures had a surface hardness of F; this is believed to be because of a more amount of a multifunctional monomer as a monomer, which allowed the structures to have a high crosslinking density and thus high surface hardness.

It was verified from Table 4 that the structure of Example 1 on which a moth eye-shaped resin was transferred did not have decreased transmittance even after UV application at 18, 000 mJ/cm², and was superior in its use also for antireflection compared with Comparative Examples 1 and 2.

The meanings of abbreviations in the table are as follows. TPGDA: tripropylene glycol diacrylate
MMA: methyl methacrylate
GMA: glycidyl methacrylate
Ir369: IRGACURE369
Ir907: IRGACURE907
Ir819: IRGACURE819
Ir184: IRGACURE184

### Industrial Applicability

The photocurable resin composition for imprinting of the present invention are employable for the production of imprinting molds, antireflection films, diffusion films and the like, and therefore are of extremely high industrial use.

## Claims

1. A photocurable resin composition for imprinting comprising a (meth) acrylic monomer (A) and a photoinitiator (B), wherein the photoinitiator (B) comprises a combination of an alkylphenone-based photoinitiator (B1) and an acylphosphine oxide-based photoinitiator (B2), wherein a blending weight ratio (B1: B2) of the alkylphenone-based photoinitiator (B1) to the acylphosphine oxide-based photoinitiator (B2) is in the range of 1:99 to 90:10.

2. The photocurable resin composition for imprinting according to claim 1, wherein with respect to 100 parts by weight of the (meth)acrylic monomer (A), the alkylphenone-based photoinitiator (B1) is contained at 0.01 to 20 parts by weight and the acylphosphine oxide-based photoinitiator (B2) is contained at 0.01 to 20 parts by weight.

3. The photocurable resin composition for imprinting according to claim 1 or 2, wherein the alkylphenone-based photoinitiator (B1) is at least one kind selected from the group consisting of 2,2-dimethoxy-1,2-diphenylethane-1-one,
1-hydroxy-cyclohexyl-phenyl-ketone,
2-hydroxy-2-methyl-1-phenyl-propane-1-one,
1-[4-(2-hydroxyethoxy)-phenyl]-2-hydroxy-2-methyl-propane-1-o ne and
2-hydroxy-1-{[4-(2-hydroxy-2-methyl-propionyl)-benzyl]phenyl} -2-methyl-propane-1-one.

4. The photocurable resin composition for imprinting according to any one of claims 1 to 3, wherein the acylphosphine oxide-based photoinitiator (B2) is at least one kind selected from the group consisting of 2,4,6-trimethylbenzoyl-diphenyl-phosphine oxide and bis(2,4,6-trimethylbenzoyl)-phenylphosphine oxide.

5. The photocurable resin composition for imprinting according to claim 4, wherein the alkylphenone-based photoinitiator (B1) is 1-hydroxy-cyclohexyl-phenyl-ketone and the acylphosphine oxide-based photoinitiator (B2) is bis(2,4,6-trimethylbenzoyl)-phenylphosphine oxide, and wherein a blending weight ratio (B1: B2) of the alkylphenone-based photoinitiator (B1) to the acylphosphine oxide-based photoinitiator (B2) is in the range of 10:90 to 70:30.

6. A method for producing a structure having a surface on which a fine pattern is formed, comprising:
(I) a step of applying, on a substrate, the photocurable resin composition for imprinting according to any one of claims 1 to 5,
(II) a step of bringing a master mold having a surface on which a fine pattern is formed into contact with the photocurable resin composition for imprinting applied on the substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

7. A method for producing a structure having a surface on which a fine pattern is formed, comprising:
(I) a step of dropwise adding the photocurable resin composition for imprinting according to any one of claims 1 to 5 on a master mold having a surface on which a fine pattern is formed,
(II) a step of covering a surface of the photocurable resin composition for imprinting with a substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

8. A structure obtained by the production method according to claim 6 or 7.

9. The structure according to claim 8, which has a fine pattern with a shrinkage factor of not more than 10% with respect to the fine pattern of the master mold.

10. The structure according to claim 8 or 9, wherein a value obtained by subtracting a YI value of the structure before irradiated with light at 18,000 mJ/cm² from a YI value of the structure after irradiated with light at 18,000 mJ/cm² is 0.0 to 3.0.

11. The structure according to any one of claims 8 to 10, which has a surface hardness of 3B to 3H in terms of pencil hardness in accordance with JIS K5600 5-4.

12. The structure according to any one of claims 8 to 11, wherein the structure is an imprinting mold.

13. The structure according to any one of claims 8 to 11, wherein the structure is an antireflection film.

14. The structure according to any one of claims 8 to 11, wherein the structure is a diffusion film.
